# EUROPEAN PATENT APPLICATION

(11) **EP 0 901 164 A2**
(43) Date of publication of application: **10.03.1999**
(21) Application number: 98460035.3
(22) Date of filing: 04.09.1998
(51) Int. Cl.: H01L 23/495, H01L 21/60

(54) **Integrated circuit packaging method, packaging apparatus, and package**

(30) Priority: 05.09.1997 US 924589
(71) Applicant: LSI LOGIC CORPORATION, Milpitas, CA 95035 (US)
(72) Inventor: Chia, Chok Joo, Cupertino, California 95014 (US); Low, Qwai Hoong, Cupertino, California 95014 (US); Ranganathan, Ramaswamy, Saratoga, California 95070 (US)
(74) Representative: Vidon, Patrice

(57) **Abstract**

An integrated circuit package is formed by placing conductive traces on a substrate and forming holes through the substrate with at least one of the holes at least partially bordered by a conductive trace. The substrate is placed over a die having die pads such that at least one hole in the substrate is aligned with a die pad. A conductive piece is inserted through a hole in the substrate to make a mechanical and electrical connection between the die pad and the conductive trace proximate the hole in the substrate.

## Description

The present invention relates to integrated circuit packaging. In particular, the present invention relates to flex tape packaging with bump bonded interconnections.

Integrated circuits are typically formed on dies, which are commonly known as chips. It is common practice for one manufacturer to create the dies and for another manufacturer to use the dies as circuit elements in larger circuits. This requires packaging the dies so they are not damaged during shipment between manufacturers and so that they can be easily mounted into a circuit board for connection to other circuit elements. A common form of die packaging uses pin packages that have conductive pins extending from a molded plastic piece. The pins can be inserted into holes in circuit boards and can be soldered to conductive traces on the boards to electrically connect the pins to other circuit elements on the board. Within the pin package, the pins are electrically connected to die pads formed on the die. The die pads form electrical connections to circuit elements within the die and provide a means for applying input signals to the dies and for retrieving output signals from the dies.

Numerous techniques have been developed for connecting dies to their pin packages. One technique, known as wire bonding, heats the end of a piece of wire to form a ball that is pressed onto and/or heated onto a die pad. The wire is then drawn out and a second end of the wire is pressed onto and/or heated onto a pin connection. In wire bonding, the die pads face away from the pin package, and the wires of the wire bonds form arcs above and between the die and the pin package. In wire bonding, the pin connections extend along the periphery of the die when the die is seated in the pin package. Thus, to minimize the length of wire needed to bond the die to the pin package, the die pads are typically placed around the periphery of the dies. The requirement that the die pads appear at the periphery of the die increases the costs of designing the dies because it requires that the designer find a way to connect all of the integrated circuit inputs and outputs to die pads that are at the periphery of the dies instead of simply connecting them to die pads located near the integrated circuits. It also increases the size of the pin package because the perimeter of the pin package must be large enough to accommodate all of the pins.

A second type of packaging is known as Tape Automated Bonding (TAB). In TAB packages, a packaging substrate is placed over the die. This packaging substrate is typically constructed from a polyamide film coated on one side with a thin conductive film that has been patterned to form conductive traces. This polyamide film is typically referred to as a tape or flex tape. The tape is connected to the die pads through tab leads, which are short metal beams that are supported by the tape with just the tips or ends of the beams extending over a periphery of the tape. These metal beams are thermally compressed onto the die pads to form a connection between the die and the conductive traces on the tape.

To reduce positioning errors associated with positioning the tape over the die, bumps are formed either on the die pads or the ends of the TAB leads. These bumps are conductive balls that increase the connection surface area between the TAB beams and the die pads. In the prior art, bumps were formed on die pads by placing conductive balls, such as gold, on the die pads and thermally compressing the balls to the die pads. Such bumping introduced an additional packaging step because the bumps had to be formed on the die pads before the beams could be compressed into the bumps. In other prior art TAB systems, which form bumps on the TAB leads or beams, the beams are selectively etched to form balls, or in the alternative, preformed balls are attached to the ends of the beams.

While wire bonding requires that the die pads face away from the remainder of the pin package, TAB construction can be used both with face-up construction, as in wire bonding, and in "flip-chip" construction. In "flip-chip" construction, the die pads face the pins, resulting in smaller packages because connections are made to pins within the perimeter of the die. When using Tape Automated Bonding construction in "flip-chip", a conductive ball is sandwiched between the conductive traces on the tape and the pin connections in the pin package. "Flip-chip" can also be accomplished without the use of flex tape, by using a solder ball to connect the die pads directly to the pin connections. However, flex tape is the preferred method since it provides greater flexibility in positioning the pins relative to the pads.

Although TAB "flip-chip" is desirable because it provides smaller packages and greater flexibility, the additional processing steps associated with TAB "flip-chip" are inefficient. Specifically, the processing steps of forming bumps on the die pads or the TAB leads are inefficient extra steps. Thus, a packaging method is needed that has the efficiency of direct "flip-chip", with the flexibility and accuracy of Tape Automated Bonding.

The present invention is an integrated circuit package and a method and apparatus for making an integrated circuit package. The invention involves forming conductive traces on a substrate and forming holes through the substrate so that at least one of the holes is at least partially bordered by a conductive trace. The substrate is then placed over a die, such that at least one hole in the substrate is aligned with a die pad on the die. A conductive piece is inserted through the hole in the substrate to make a mechanical and electrical connection between the die pad and the substrate's conductive trace.

In preferred embodiments, the conductive piece is inserted by a wire bonding machine that forms a bulbous head at the end of a piece of wire. The wire bonding machine inserts the bulbous head into the hole in the substrate so that the head makes contact with the die pad. The bonding machine then severs the wire at the opposite end of the bulbous head. The bulbous head is formed by heating the wire and the bulbous head is severed from the wire by moving the apparatus holding the wire along the plane of the substrate.

In further preferred embodiments, the package is formed through a "flip-chip" process. The conductive traces on the substrate form conductive pads and solder balls are deposited on the conductive pads. The die and substrate are then flipped onto a pin package and the solder balls are heated so that they flow and make contact with the pin connections in the pin package.

The present invention eliminates the extra steps found in other Tape Automated Bonding methods. In particular, it combines the step of forming a bump with the step of connecting the bump to a conductive trace on the flex tape. Instead of forming the bump on the die and then connecting a conductive beam to the bump, the present invention forms and connects a bump to both the flex tape and the die pad at the same time.

The invention is described in detail in connection with the drawings in which:
Fig. 1 is a perspective view of a wafer containing a matrix of dies with an enlarged portion 22.
Fig. 2 is a perspective view of a die seated in a pin package.
Fig. 3 is a cross-section of one embodiment of the integrated circuit package of the present invention.
Fig. 4 is a cross-section of a second embodiment of the integrated circuit package of the present invention.
Fig. 5 is a bottom view of the flex tape of the second embodiment of the present invention.
Fig. 6 is a flow diagram of the method of packaging of the present invention.
Fig. 7 is a block diagram of a packaging system of the present invention.

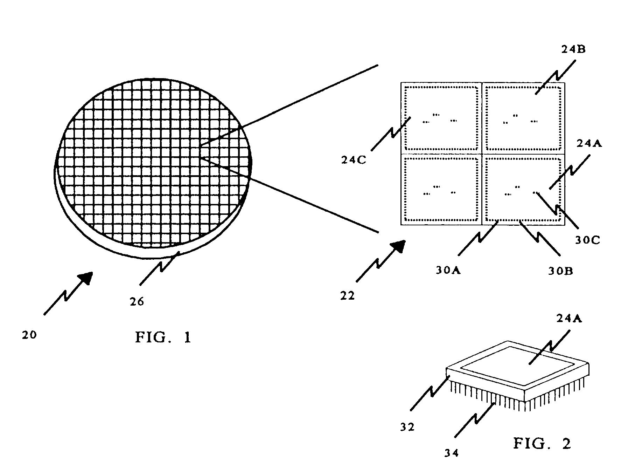

Fig. 1 is a diagram of a wafer 20 with a portion 22 shown in enlarged form. As shown in the enlarged portion 22, wafer 20 consists of a matrix of dies such as dies 24A, 24B, and 24C. Each of the dies consists of circuit components and conductive traces (not shown) that have been deposited on or diffused into a silicon substrate 26, which forms the bulk of wafer 20. Each die has bond pads such as bond pads 30A and 30B of die 24A. A series of bond pads generally extends around the perimeter of the dies and each bond pad is a relatively large conductive surface that connects to conductive traces within a die. There are also bond pads located near the center of the dies, such as bond pad 30C of die 24A. The bond pads permit input and power signals to be delivered to the dies and output signals to be delivered from the dies to external circuits.

After being cut from the wafer, the dies are connected to external circuits through a package such as package 32 of Fig. 2. Package 32 contains pins 34 that can be soldered to a circuit board to make connections with other circuit components. In Fig. 2, pin package 32 is connected to die 24A through solder bonds (not shown), which are bonded to die 24A and to pin connections on pins 34. The package shown in Fig. 2 is typically referred to as a "flip-chip" package design wherein the connections between the die and the pin package are in a layer between the die and the pin package.

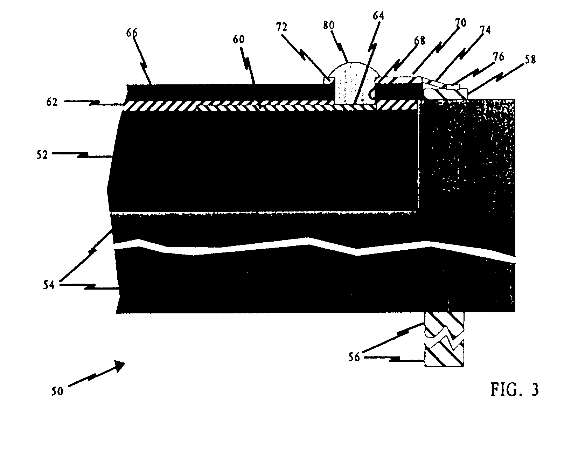

Fig. 3 is a cross-sectional diagram of an integrated circuit package 50, which represents a first embodiment of the present invention. In Fig. 3, die 52 is seated within pin package 54 having a pin 56. Pin 56 is electrically connected to pin connection 58 located at the top of pin package 54.

Die 52 is partially covered by metalization layer 60, which is patterned to form traces on die 52. Metalization layer 60 is a conductive material, typically an aluminum alloy. Passivation layer 62 covers the portions of die 52 not covered by metalization layer 60 and covers nearly all of metalization layer 60. Passivation layer 62 is an insulator, preferably silicon-oxide. The portions of metalization layer 60 not covered by passivation layer 62 define the die pads for die 52. For instance, die pad 64 of Fig. 3 is defined in an area where passivation layer 62 does not cover metalization layer 60.

A thin film polyamide tape 66 covers passivation layer 62 and a portion of pin package 54, such that holes in thin film polyamide tape 66 are aligned with die pads on die 52. For instance, hole 68 in thin film polyamide tape 66 aligns with die pad 64 in Fig. 3. Thin film polyamide tape 66 is laminated with a thin film of conductive material, preferably copper, that has been patterned to form conductive traces. The conductive traces form conductive rings that surround holes in thin film polyamide tape 66, as well as conductive beams that extend beyond the peripheral edge of thin film polyamide tape 66. For instance, in Fig. 3, trace 70 forms ring 72 around hole 68 and forms beam 74 that extends beyond thin film polyamide tape 66. Beam 74 ends in contact bump 76, which is pressed downward to make a thermal compressive bond to pin contact 58. Thus, pin 56 is electrically connected to trace 70.

A wire bump 80, preferably made of Gold, is inserted through ring 72 of trace 70, and hole 68 of polyamide thin film tape 66 to make electrical and mechanical contact with die pad 64. Wire bump 80 is pressed into hole 68 such that a portion of wire bump 80 contacts the top surface of ring 72; the top surface being opposite the surface of ring 72 in contact with polyamide thin film tape 66. Wire bump 80 thus presses ring 72 toward polyamide thin film tape 66 and die 52, while making an electrical connection between ring 72 and die pad 64. Thus, die pad 64, trace 70, and pin 56 are electrically connected.

Although integrated circuit package 50 was described with reference to a single pin 56, a single trace 70, a single wire bump 80 and a single die pad 64, those skilled in the art will recognize that there are multiple pins, traces, wire bumps, and die pads that comprise integrated circuit package 50.

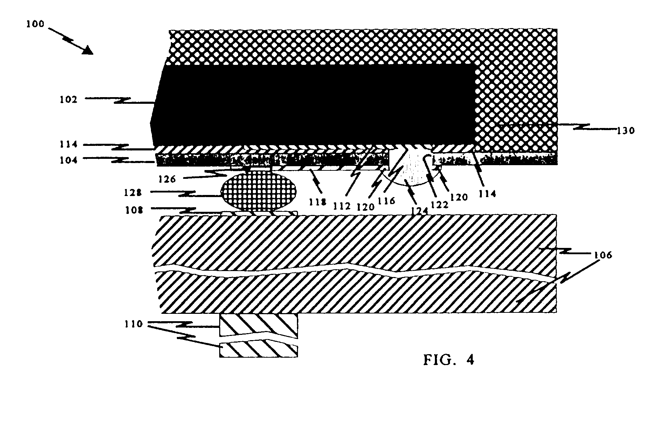

Fig. 4 is a cross-sectional view of integrated circuit package 100 showing a second embodiment of the present invention. Integrated circuit package 100 is a "flip-chip" design wherein die 102 and polyamide thin film 104 have been flipped onto pin package 106 having pin connections 108 and pins 110. Similar to Fig. 3, die 102 is partially covered by patterned conductive traces 112. Passivation layer 114 covers the remainder of die 102 and most of patterned conductive traces 112. The small portions of patterned conductive traces 112 that are not covered by passivation layer 114 form die pads 116 on die 102.

Polyamide thin film 104 covers passivation layer 114 and is laminated with conductive traces, preferably formed of copper. The conductive traces form patterned conduction paths on polyamide thin film 104 and include conductive rings formed around holes in polyamide thin film 104. For instance, conductive trace 118 forms conductive ring 120 around hole 122. A conductive bump 124, preferably formed of Gold, covers a portion of ring 120 and extends through hole 122 to make contact with die pad 116. Conductive bump 124 provides a mechanical and an electrical connection between conductive trace 118 and die pad 116.

The conductive traces also include conductive pads that are bumped with a solder ball prior to "flipping" the die onto pin package 106. For example, conductive trace 118 forms conductive pad 126 that is bumped with solder ball 128. Solder ball 128 may be thermally compressed or adhesively adhered to conductive pad 126. When die 102 is flipped onto pin package 106, solder ball 128 aligns with pin connection 108 and is connected to pin connection 108 through an adhesive bond or by heating solder ball 128 so that it flows onto pin connection 108 and bonds with pin connection 108. After die 102 has been flipped onto pin package 106, an electrical connection extends from pins 110 through pin connection 108, solder ball 128, conductive pad 126, conductive traces 118, conductive rings 120, and conductive bump 124 to die pad 116.

In Fig. 4, die 102 is shown surrounded by a filler material 130 which is preferably a molded plastic used to hold the polyamide thin film in rigidity. The rigidity is needed to accommodate conductive pads that extend beyond the die on polyamide thin film 104. Although such pads are not shown in Fig. 4, those skilled in the art will recognize that such placement is easily accommodated by the embodiment of Fig. 4.

Although only one pin, one conductive trace, and one die pad is shown in Fig. 4 for simplicity, those skilled in the art will recognize that the integrated circuit package of the present invention comprises a large number of pins, traces and die pads with a similar structure to those shown in Fig. 4.

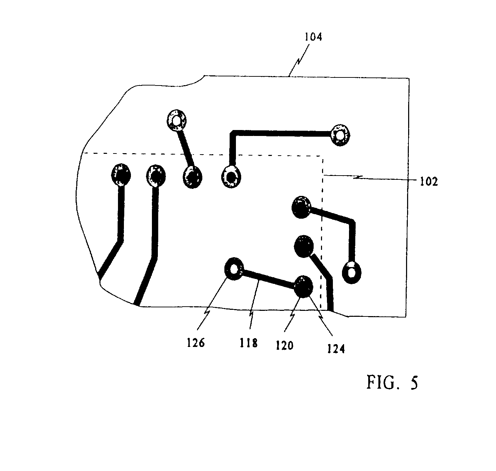

Fig. 5 is a bottom view of a portion of the integrated circuit package of Fig. 4. In particular, Fig. 5 shows polyamide thin film 104 before solder balls have been added to the conductive pads but after polyamide thin film 104 has been connected to die 102 through conductive bumps. For instance, conductive pad 126 of trace 118 is not yet bumped with a solder ball, but conductive bump 124 has been placed through polyamide thin film 104 to connect ring 120 to a die pad (not shown) of die 102. The outline of die 102 is shown with a dotted line since die 102 is covered by polyamide thin film 104.

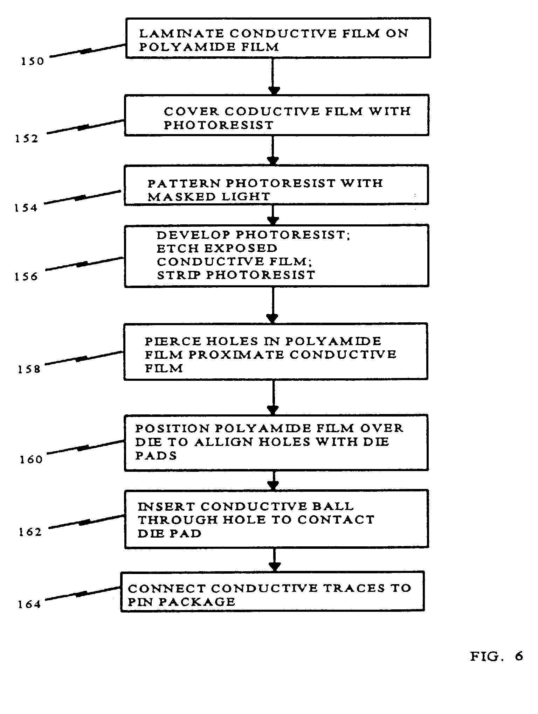

Fig. 6 is a flow diagram of a process for manufacturing an integrated circuit package of the present invention. First, a conductive film is laminated onto a polyamide film at process step 150. The conductive film is then coated with a photoresist at step 152. The photoresist is patterned with a masked light at step 154. The masked light may be formed with a contact mask or with some other form of masking. The photoresist is developed in step 156 so that unwanted portions of the photoresist are removed. For positive photoresists, the exposed portions of the photoresist are removed by the development of the photoresist. For negative photoresists, the masked portions are removed during development. The portions of the conductive film that are exposed by the development of the photoresist are etched to eliminate the conductive film in those portions. After the conductive film has been etched, the remaining photoresist is stripped from the remaining conductive film.

In step 158, holes are pierced in the polyamide film proximate portions of the conductive film. In one preferred embodiment, patterning steps 152, 154, and 156, form rings in the conductive film. The holes are then preferably pierced in the center of these rings leaving only a hole surrounded by conductive material. After holes have been pierced through the polyamide film, the film is positioned over the die to align the holes with the die pads in step 160. After the holes have been aligned with the die pads, a conductive ball is inserted through the hole to contact the die pad and the conductive film in step 162. In preferred embodiments, the conductive ball is formed by a wire bonding machine, which heats the end of a piece of gold wire using a laser or an electric arc so that the wire melts and contracts into a bulbous shape. The bulbous shape is then inserted through the holes to contact the die pad. The wire bonding machine then moves in a plane parallel to the die pads and perpendicular to the holes in the polyamide film in order to sever the wire at its bulbous end, thereby leaving a conductive ball in the hole.

Once each of the die pads has been connected to a trace on the conductive film in step 162, the conductive traces are further connected to a pin package in step 164. This connection can be accomplished by using either "flip-chip" technology or a TAB process. In "flip-chip", solder balls are bumped onto pads formed on the conductive traces and then the die/polyamide film combination is flipped onto a pin package. In the Tape Automated Bonding process, the conductive traces form beams that extend beyond the periphery of the polyamide film. These beams are thermally compressed into pin connections on the pin package.

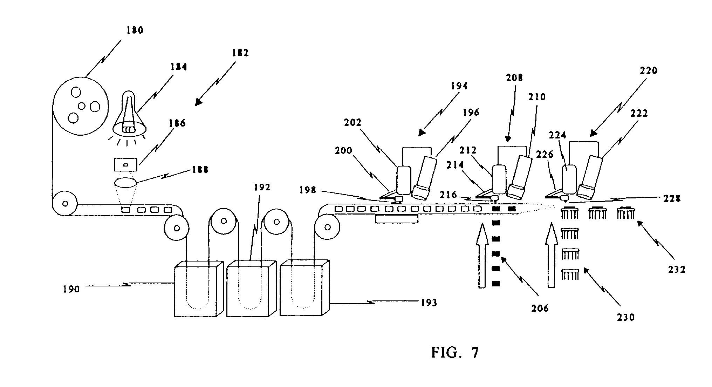

Fig. 7 shows a system for manufacturing an integrated circuit package of the present invention. A reel 180 provides a web of polyamide thin film laminated with a conductive material and further coated with a photoresist to a photolithography unit 182. Photolithography unit 182 comprises light source 184, mask 186 and lense 188. Mask 186 contains the desired pattern for the traces to be etched out of the conductive material on the polyamide thin film. Light source 184 provides a wavelength of light that is reactive with the photoresist and passes through mask 186 and lense 188 onto the photoresist. Once exposed, the web of material passes through a developer 190 that develops the photoresist removing a portion of the photoresist to expose portions of the conductive film. The web passes from the developer 190 to etchant 192 which etches away the exposed conductive material, leaving the desired conductive traces including, in preferred embodiments, conductive rings. The web then passes to a photoresist stripper 193, which strips the remaining photoresist, leaving only the patterned conductive traces. Although etchant 192 and stripper 193 are shown as wet etchants and wet strippers, those skilled in the art will recognize that dry etchants and dry strippers may also be used.

The web proceeds from stripper 193 to a drill press 194, which includes camera 196, piercing bit 198, robotic arm 200, and control unit 202. Control unit 202 processes image data from camera 196 to locate the position where holes are to be pierced into the polyamide film. In preferred embodiments, control unit 202 uses a template which is compared against the traces found on the polyamide film and which includes the desired location for the holes in the polyamide film. Based on the image data and the template, control unit 202 moves robotic arm 200 to various locations across the polyamide film and pierces holes through the polyamide film at the desired location using piercing bit 198, which is located at the end of robotic arm 200. Piercing bit 198 may be a high speed drill bit, a focused laser beam, or a sharp punch. In preferred embodiments, control unit 202 pierces holes through areas of the polyamide thin film surrounded by a ring of conductive material.

Once the holes have been formed in the polyamide film, the conductive traces are oriented over a die from a die stream 206, and a wire bonding unit 208 aligns the holes in the polyamide film with the die pads found on the die. Wire bonding unit 208 includes camera 210, control unit 212, robotic arm 214 and wire bonder 216, which is located at the end of robotic arm 214. Camera 210 provides video data to control unit 212 so that it may align the holes of the polyamide thin film with the die pads of the die. Further, once the thin film is aligned with the die, control unit 212 moves robotic arm 214 to position wire bonder 216 over a hole in the polyamide thin film. Prior to being moved, wire bonder 216 forms a bulbous head at the end of a piece of wire. Once positioned over the hole, wire bonder 216 inserts the bulbous end into the hole in the polyamide film making contact with the die pad. Control unit 212 then moves robotic arm 214 in the plane of the die, perpendicular to the hole in the polyamide thin film to sever the wire at the bulbous head. Wire bonder 216 then forms a new bulbous head by heating the newly severed end of the wire. This process is repeated until each of the holes over a die pad has been bumped with a conductive ball. The polyamide film over the die is then cut from the remaining polyamide film and the individual dies are advanced to a pin packaging unit 220.

Pin packaging unit 220 may be a "flip-chip" packaging unit or a Tape Automated Bonding (TAB) machine. Pin packaging unit 220 includes a camera unit 222, control unit 224, robotic arm 226 and a bonding unit 228. Control unit 224 uses video data from camera 222 to position the die over a pin package selected from a pin package stream 230. Control unit 224 then moves robotic arm 226 to position bonding unit 228 over the die. In a "flip-chip" system, bonding unit 228 reflows bumped solder balls on the polyamide thin film so that they make connections with pin connection points on the pin packages. In a TAB system, bonding unit 228 thermally compresses beams formed of conductive traces that extend beyond the periphery of the polyamide thin film over pin contact areas on the pin packages.

Once the die has been connected to the pin package, the final integrated circuit package 232 is ready for testing.

Although the present invention has been described with reference to preferred embodiments, workers skilled in the art will recognize that changes may be made in form and detail without departing from the spirit and scope of the invention.

## Claims

1. An integrated circuit package comprising:
a substrate having electrically conductive traces, at least one of the electrically conductive traces bordering at least one hole in the substrate;
a die proximate the substrate and having at least one die pad aligned with one hole in the substrate;
an electrically conductive plug within a hole in the substrate, the electrically conductive plug electrically connecting at least one electrically conductive trace on the substrate to a die pad, at least part of a conductive trace being located between the substrate and the electrically conductive plug.

2. The integrated circuit package of claim 1 wherein a conductive trace surrounds at least one hole in the substrate.

3. The integrated circuit package of claim 1 wherein the substrate comprises: at least one electrically conductive pad connected to an electrically conductive trace bordering at least one hole in the substrate.

4. The integrated circuit package of claim 3 wherein the electrically conductive pad is on a first side of the substrate and the die is on a second side of the substrate, the first and second sides opposite each other.

5. The integrated circuit package of claim 4 wherein the electrically conductive pad is further connected to a pin package having a base and pins extending from the base.

6. The integrated circuit package of claim 5 wherein the substrate and die are flipped onto the base of the pin package to connect the electrically conductive pad to the pin package.

7. The integrated circuit package of claim 6 wherein the electrically conductive pad is connected to the pin package through a conductive ball adhered to the conductive pad and the pin package.

8. The integrated circuit package of claim 1 wherein the electrically conductive plug is spherically shaped before being inserted through the hole in the substrate.

9. The integrated circuit package of claim 8 wherein the electrically conductive plug is inserted in the hole in the substrate to make contact with the die.

10. The integrated circuit package of claim 9 wherein the electrically conductive plug is formed from conductive wire that has been heated to form a bulbous end.

11. A method for creating an integrated circuit package, the method comprising:
forming conductive traces on a substrate;
forming holes through the substrate, at least one of the holes at least partially bordered by a conductive trace;
placing the substrate over a die having die pads, the substrate positioned over the die such that at least one hole in the substrate is aligned with a die pad; and
inserting a conductive piece through a hole in the substrate to make a mechanical connection and an electrical connection between the die pad and a conductive trace bordering the hole in the substrate.

12. The method of claim 11 wherein a conductive trace surrounds the entirety of a hole in the substrate.

13. The method of claim 11 wherein the conductive piece is formed from wire that has been heated to form a bulbous end.

14. The method of claim 13 wherein the conductive piece is inserted in the hole by a wire bonding machine that breaks the wire at the bulbous end by moving relative to the hole after placing the bulbous end in the hole.

15. The method of claim 11 further comprising:
placing conductive bumps on conductive pads formed by the conductive traces; connecting the conductive bumps to a pin package, the pin package having conductive pins for connection to other circuit elements, the conductive pins connected to the conductive bumps through electrical conductors.

16. The method of claim 15 wherein the conductive bumps are placed on a first side of the substrate and the die is placed on a second side of the substrate opposite the first side.

17. A system for manufacturing integrated circuit packages, the system comprising:
thin film depositing means for depositing a thin film of conductive material on a substrate;
patterning means for patterning the thin film of conductive material to form traces of conductive material;
piercing means for creating holes in the substrate, at least one of the holes partially bordered by a trace of conductive material;
positioning means for positioning the substrate relative to a die such that a die pad on the die is aligned with at least one hole in the substrate; and
bonding means for bonding the substrate to the die by inserting a conductive material through a hole in the substrate so that the inserted conductive material contacts both a trace of conductive material and a die pad.

18. The system of claim 17 wherein the bonding means is a wire bonder and the conductive material is a ball formed at an end of a wire by the wire bonder, the ball formed by heating the end of the wire.

19. The system of claim 17 wherein the piercing means pierces an area surrounded by traces of conductive material.

20. The system of claim 17 wherein the substrate is a flex tape.
